# EUROPEAN PATENT APPLICATION

(11) **EP 4 488 409 A1**
(43) Date of publication of application: **08.01.2025**
(21) Application number: 23763511.5
(22) Date of filing: 01.03.2023
(51) Int. Cl.: C23C 18/20, H01L 21/288

(54) **NONELECTROLYTIC PLATING PRIMER COMPOSITION, LAMINATE, AND METHOD FOR MANUFACTURING SAME**

(30) Priority: 04.03.2022 JP 2022033771
(71) Applicant: Mitsui Chemicals, Inc., Tokyo 104-0028 (JP); Iox Co., Ltd., Higashiosaka-shi, Osaka 577-0835 (JP)
(72) Inventor: KOYAMA, Taichi, Chiba 299-0265 (JP); NAKATSUJI, Tatsuya, Osaka 577-0835 (JP)
(74) Representative: Hoffmann Eitle
(86) International application number: PCT/JP2023/007670
(87) International publication number: WO 2023/167254

(57) **Abstract**

A nonelectrolytic plating primer composition according to the present invention contains a phenoxy resin (A), and 25-65 parts by mass of a melamine resin (B) with respect to 100 parts by mass of the phenoxy resin (A).

## Description

### Technical Field

The present invention relates to a primer composition for non-electrolytic plating (herein also simply referred to as "non-electrolytic plating primer composition"), a laminate, and a manufacturing method thereof.

### Background Art

The technology of forming a metal plating layer on an insulation base material such as a resin base material is utilized when manufacturing a conductive film for electromagnetic wave shielding, decorative plating for the purpose of providing a design, and an electronic component such as an integrated circuit or a resistor. In particular, when manufacturing a printed wiring board used in electronic equipment, a technique of forming a plating layer is utilized when forming a conductive wiring pattern on an insulation base material.

For forming a plating layer, it has been studied to provide an anchor effect by performing etching (roughening) to form fine irregularities on the surface of the insulation base material in order to increase the adhesiveness between the insulation base material and the plating layer. However, this etching has a problem in that, in addition to complicating the process, the transmission loss is more likely to increase due to a skin effect in a highfrequency-compatible device for 5G.

In contrast, a method has been studied in which an insulation base material and a plating layer are brought into close contact with each other without performing etching. For example, a method is known in which a base layer (primer layer) including a non-electrolytic plating catalyst is formed on the surface of an insulation base material, and then a plating layer is formed (see, for example, Patent Literature (hereinafter, referred to as PTL) 1).

### Citation List

### Patent Literature

PTL 1
Japanese Patent Application Laid-Open No. 2013-209643

### Summary of Invention

### Technical Problem

Formation of a plating layer on the surface of an insulation base material is usually performed after a primer layer is formed on the surface of the insulation base material, by bringing the primer layer into contact with a non-electrolytic plating solution or the like. These steps are usually performed with a roll-to-roll method. However, in a case where the coating film strength of the primer layer (the strength of the primer layer as a coating film) is not sufficient, the surface of the primer layer is more likely to become uneven, and further, the primer layer may be peeled off from the insulation base material (delamination may occur) or the surface of the primer layer may be scratched due to friction with a roll. For this reason, it is desired to enhance the coating film strength of the primer layer. Even now, it is desired to further enhance the coating film strength in the primer layer of PTL 1.

When the coating film strength of the primer layer is too high, the surface may become too hard, the reactivity with the non-electrolytic plating solution may decrease, and it may be impossible to form the plating layer uniformly. Further, when the coating film strength of the primer layer is too high, the adhesiveness with the insulation base material may also be impaired.

An object of the present invention is to provide a non-electrolytic plating primer composition, a laminate, and a manufacturing method thereof each capable of providing a primer layer having a sufficient coating film strength without decreasing reactivity with a non-electrolytic plating solution and adhesiveness.

### Solution to Problem

[1] A non-electrolytic plating primer composition containing: a phenoxy resin (A); and 25 to 65 parts by mass of a melamine resin (B) based on 100 parts by mass of the phenoxy resin (A).
[2] The non-electrolytic plating primer composition according to [1], further containing: an epoxy resin (C); and a resol phenol resin (D).
[3] The non-electrolytic plating primer composition according to [2], in which a total amount of the epoxy resin (C) and the resol phenol resin (D) is 30 to 80 parts by mass based on 100 parts by mass of the phenoxy resin (A).
[4] The non-electrolytic plating primer composition according to [2] or [3], in which the epoxy resin (C) is a polyfunctional epoxy resin including three or more epoxy groups in a molecule thereof.
[5] The non-electrolytic plating primer composition according to any one of [2] to [4], in which the epoxy resin (C) is a solid epoxy resin.
[6] The non-electrolytic plating primer composition according to according to any one of [1] to [5], further containing a palladium catalyst.
[7] The non-electrolytic plating primer composition according to [6], in which the palladium catalyst is a palladium particle; and an average particle size of the palladium particle is 2 to 10 nm.
[8] The non-electrolytic plating primer composition according to [6] or [7], in which a content of the palladium catalyst is 0.1% to 30% by mass with respect to a non-volatile component of the non-electrolytic plating primer composition.
[9] The non-electrolytic plating primer composition according to any one of [6] to [8], further containing: a silica particle.
[10] A laminate including: an insulation base material; a primer layer disposed on the insulation base material and including a cured product of the non-electrolytic plating primer composition of the present invention; and a metal plating layer disposed on the primer layer.
[11] The laminate according to [10], in which the insulation base material includes a resin selected from the group consisting of polyimide, BT resin, polyetheretherketone, cyclic polyolefin, polyphenylene sulfide, liquid crystal polymer, and fluororesin, the resin having a low dielectric constant.
[12] A method for manufacturing a laminate, the method including: forming a primer layer by applying the non-electrolytic plating primer composition of the present invention to a surface of an insulation base material and by drying and curing the applied non-electrolytic plating primer composition; and forming a metal plating layer on the primer layer by non-electrolytic plating.

### Advantageous Effects of Invention

According to the present invention, it is possible to provide a non-electrolytic plating primer composition, a laminate, and a manufacturing method thereof each capable of providing a primer layer having a sufficient coating film strength without decreasing reactivity with a non-electrolytic plating solution.

### Description of Embodiments

The present inventors have made intensive studies on the composition of a primer composition which can satisfactorily undergo a curing reaction in a short time to provide a cured product having a high coating film strength, and have found that the combination of a phenoxy resin (A) and a melamine resin (B) is preferable. Further, the present inventors have found that the reactivity with a non-electrolytic plating solution and the adhesiveness can be satisfactorily maintained by adjusting the content of the melamine resin (B) to a predetermined range.

Although not clear, the mechanism can be deduced as follows. The phenoxy resin (A) has not only a strong structure but also a large number of hydroxyl groups in the molecule thereof. For this reason, hydroxyl groups of the phenoxy resin (A) can react with methylol groups of the melamine resin (B) or the like to form a highly dense crosslinked structure, and thus, a cured product with a high surface hardness is obtained. On the other hand, when the amount of the melamine resin (B) is too large, the surface hardness of the cured product becomes too high. As a result, to expose the palladium catalyst, which serves as a core for reaction with the non-electrolytic plating solution, to the surface becomes difficult or to keep the state stable when the palladium catalyst is applied to the cured product of the primer composition becomes difficult. The reactivity with the non-electrolytic plating solution is thus likely to be impaired. Further, when the cured product becomes too hard, adhesiveness is also likely to be impaired. In contrast, by appropriately adjusting the content of the melamine resin (B), it is possible to obtain a cured product having a moderate strength, and thus, it is possible to prevent the above-described problems. Such a primer composition is suitable for a process of forming a plating film in a roll-to-roll manner.

Further, by further adding the epoxy resin (C) and the resol phenol resin (D) in addition to the above components, the adhesiveness of the cured product of the primer composition can be further enhanced. That is, the methyloxy hydroxyl group or the phenolic hydroxyl group of the resol phenol resin (D) can cause the epoxy resin (C) to be easily cured and can generate a hydroxyl group in the reaction process (ring-opening reaction) by reacting with the epoxy group of the epoxy resin (C). Thus, it is considered that the adhesiveness with the insulation base material is effectively increased.

Hereinafter, the configuration of a primer composition of the present invention will be described in detail.

### 1. Primer composition

The primer composition of the present invention includes a phenoxy resin (A) and a melamine resin (B).

### 1-1. Phenoxy resin (A)

The phenoxy resin (A) is a polymer having a polyhydroxypolyether structure obtained by subjecting a polyfunctional phenol and a polyfunctional glycidyl ether (preferably a bisphenol and epichlorohydrin) to a polyaddition reaction.

The weight average molecular weight (Mw) of the phenoxy resin (A) is usually 10,000 to 200,000, preferably 20,000 to 100,000, more preferably 30,000 to 80,000. When the Mw of the phenoxy resin (A) is equal to or larger than a certain value, the cured product of the primer composition having a high coating film strength is easily obtained, and when the Mw is equal to or less than the certain value, the viscosity of the primer composition does not excessively increase, and the handleability is less likely to be impaired. The Mw of the phenoxy resin (A) can be determined by performing gel permeation chromatography (GPC) using tetrahydrofuran (THF) as a solvent and calculating the value as a standard polystyrene equivalent.

The secondary hydroxyl equivalent of the phenoxy resin (A) is not particularly limited, but is preferably 240 g/eq or more, more preferably 250 to 290 g/eq. When the secondary hydroxyl equivalent of the phenoxy resin (A) is within the above range, the phenoxy resin (A) includes a large number of hydroxyl groups, and thus, is not only reacts more easily with the melamine resin (B) but also is more likely to have improved adhesiveness to an insulation base material.

The phenoxy resin (A) may have an epoxy group in a molecule thereof. The epoxy equivalent of the phenoxy resin (A) is preferably 5000 g/eq or more, more preferably 6500 g/eq or more. The epoxy equivalent can be measured in accordance with JIS K7236.

Examples of the phenoxy resin (A) include bisphenol A-type phenoxy resin, bisphenol F-type phenoxy resin, bisphenol S-type phenoxy resin, a copolymerization type phenoxy resin of bisphenol A-type and bisphenol F-type (bisphenol AF-type phenoxy resin), bisphenol E-type phenoxy resin, naphthalene-type phenoxy resin, novolak-type phenoxy resin, biphenyl-type phenoxy resin, and cyclopentadiene-type phenoxy resin. The phenoxy resin (A) can be used alone or in combination of two or more types.

Commercial product examples of the phenoxy resin (A) include jER4250 (produced by Mitsubishi Chemical Corporation, a bisphenol A-type phenoxy resin/bisphenol F-type phenoxy resin mixed type, epoxy equivalent: 7500 to 8900 g/eq), YX7200B35 (produced by Mitsubishi Chemical Corporation, phenoxy resin containing a biphenyl skeleton and a cyclohexane skeleton, epoxy equivalent: 9000 g/eq), 1256 (produced by Mitsubishi Chemical Corporation, phenoxy resin containing a bisphenol A skeleton, epoxy equivalent: 7,800 g/eq), YX6954BH35 (produced by Mitsubishi Chemical Corporation, phenoxy resin containing a bisphenol acetophenone skeleton, epoxy equivalent: 13,000 g/eq), and the like.

Since the phenoxy resin (A) contains a large number of hydroxyl groups in the molecule, the phenoxy resin (A) can satisfactorily react (curing reaction) with the melamine resin (B). Thus, the cured product of a primer composition including these resins has a high coating film strength.

The content of the phenoxy resin (A) is preferably 20 to 65% by mass, more preferably 30 to 60% by mass, with respect to the non-volatile component of the primer composition. When the content of the phenoxy resin (A) is equal to or larger than a certain value, the cured product of the primer composition may have a high coating film strength because the melamine resin (B) can be subjected to the curing reaction with the phenoxy resin (A) sufficiently. In the present specification, the non-volatile component refers to the components constituting the composition other than a solvent.

### 1-2. Melamine resin (B)

The melamine resin (B) can function as a curing agent that cures the phenoxy resin (A) by reacting with the hydroxyl group included in the phenoxy resin (A).

Such melamine resin (B) may be melamine, a methylolated melamine derivative obtained by condensing melamine and formaldehyde, a compound partially or completely etherified by reacting methylolated melamine with a lower alcohol, or a mixture thereof. The melamine resin (B) may be either a monomer or a condensate of a dimer or higher polymer.

Examples of the lower alcohol used for the etherification include methyl alcohol, ethyl alcohol, isopropyl alcohol, n-butanol, and isobutanol. That is, the melamine resin (B) includes a functional group such as an imino group, a methylol group, and an alkoxymethyl group (for example, a methoxymethyl group or a butoxymethyl group). Specifically, the imino group-type methylated melamine resin, the methylol group-type melamine resin, the methylol group-type methylated melamine resin, and the fully alkylated methylated melamine resin are included, and among these, the methylolated melamine resin is preferable.

Commercial product examples of the melamine resin (B) include Nikarac MW-100LM, Nikarac MW-30, Nikarac MW-30M, Nikarac MW-22, Nikarac MW-22A, Nikarac MS-11, Nikarac MX-750 (manufactured by Sanwa Chemical Co., Ltd.), Saimel 300, Saimel 301, Saimel 350 (manufactured by Mitsui Cyanamid Co., Ltd.), and U-VAN 703 (manufactured by Mitsui Chemicals, Inc.). The melamine resin (B) may be used alone or may be used in combination of two or more types.

Regarding the melamine resin (B), since the reaction (curing reaction) between the hydroxyl group contained in the phenoxy resin (A) and the melamine resin (B) is more likely to proceed in addition to the self-condensation of the melamine resin (B), the coating film strength of the cured product of the primer composition is improved.

The content of the melamine resin (B) is 25 to 65 parts by mass based on 100 parts by mass of the phenoxy resin (A). When the content of the melamine resin (B) is 25 mass parts or more based on 100 mass parts of the phenoxy resin (A), the curing reaction between the phenoxy resin (A) and the melamine resin (B) can be performed sufficiently, and thus, the cured product of the primer composition has a high coating film strength and excellent abrasion resistance. When the content of the melamine resin (B) is 65 mass parts or less based on 100 mass parts of the phenoxy resin (A), the cured product of the primer composition may have an appropriate flexibility without becoming too hard. Thus, the reactivity with the non-electrolytic plating solution in a process below is less likely to decrease, and the adhesiveness is less likely to be impaired. From the same viewpoint, the content of the melamine resin (B) is preferably 30 to 60 parts by mass based on 100 parts by mass of the phenoxy resin (A), and more preferably 35 to 55 parts by mass.

### 1-3. Additional components

The primer composition of the present invention may further contain any additional component other than those described above, as necessary. For example, from the viewpoint of easily further enhancing the adhesive strength and the adhesion reliability, it is preferable that the primer composition of the present invention further include an epoxy resin (C) and a resol phenol resin (D).

### 1-3-1. Epoxy resin (C)

The epoxy resin (C) is resin having an epoxy group, excluding the above-described phenoxy resin (A). The epoxy resin (C) preferably contains difunctional epoxy resin having two or more epoxy groups in a molecule thereof, and more preferably contains polyfunctional epoxy resin having three or more epoxy groups in a molecule thereof. A polyfunctional epoxy resin having three or more epoxy groups in a molecule thereof has many reaction points with, for example, the resol phenol resin (D), and therefore many hydroxyl groups are generated by ring-opening of the epoxy groups, making it particularly easy to enhance the adhesiveness. The epoxy resin (C) may be used alone or may be used in combination of two or more types.

Examples of the epoxy resin (C) include epoxy resin having an aromatic ring (aromatic epoxy resin), such as bisphenol A-type epoxy resin, bisphenol F-type epoxy resin, bisphenol S-type epoxy resin, bisphenol AF-type epoxy resin, bixylenol-type epoxy resin, trisphenol-type epoxy resin, naphthol novolac-type epoxy resin, phenol novolac-type epoxy resin, cresol novolac-type epoxy resin, tert-butyl-catechol-type epoxy resin, naphthalene-type epoxy resin, anthracene-type epoxy resin, biphenyl-type epoxy resin, cyclopentadiene-type epoxy resin, tetraphenylethane-type epoxy resin, and aminophenol-type epoxy resin; alicyclic epoxy resin, such as cyclohexane dimethanol-type epoxy resin; and aliphatic epoxy resin, such as trimethylol-type epoxy resin.

Among these, aromatic epoxy resin is preferable from the viewpoint of easily enhancing the adhesion reliability. Examples of the polyfunctional aromatic epoxy resin having three or more epoxy groups in a molecule thereof include naphthalene tetrafunctional epoxy resin, cresol novolac-type epoxy resin, phenol novolac-type epoxy resin, triphenol-type epoxy resin, bisphenol A-type epoxy resin, bisphenol AF-type epoxy resin, and tetraphenylethane-type epoxy resin. Commercial product examples include "jER1031S" (tetraphenylethane epoxy resin) and "157570" (bisphenol novolac epoxy resin).

The epoxy resin (C) may be liquid epoxy resin or solid epoxy resin. From the viewpoint of easily increasing the coating film strength, solid epoxy resin is preferable. Here, the term "liquid" means being in a liquid state at 20°C, and the term "solid" means being in a solid state at 20°C.

The epoxy equivalent of the epoxy resin (C) is not particularly limited, but is preferably less than 5000 g/eq. On the other hand, the epoxy equivalent of the phenoxy resin (A) is preferably 5000 g/eq or more. As described above, the phenoxy resin (A) may have an epoxy group in the molecule, in the same manner as the epoxy resin (C), but the phenoxy resin (A) and the epoxy resin (C) can be distinguished from each other in terms of the epoxy equivalent in the present specification.

The epoxy equivalent of the epoxy resin (C) is, from the viewpoint of the reactivity, preferably 50 to 3000 g/eq, more preferably 100 to 1000 g/eq, and still more preferably 140 to 300 g/eq. When the epoxy equivalent is within the above-described range, it is possible to achieve sufficient curing without impairing the coatability of the primer composition. The epoxy equivalent can be measured in the same manner as described above.

The weight average molecular weight (Mw) of the epoxy resin (C) is not particularly limited, but is preferably 1000 or less. The Mw of the epoxy resin (C) is the weight average molecular weight in standard polystyrene conversion measured by GPC in the same manner as described above.

### 1-3-2. Resol phenol resin (D)

The resol phenol resin (D) can function as a polyaddition-type epoxy resin curing agent for the epoxy resin (C). That is, at least one of the phenolic OH group and the methylol group of the resol phenol resin (D) can undergo addition reaction with the epoxy group of the epoxy resin (C). Thus, it is possible to apply a primer composition with satisfactory adhesion reliability.

Examples of the resol phenol resin (D) include phenol-type resin, cresol-type resin, alkyl-type resin, bisphenol A-type resin, and copolymers thereof. Commercial product examples of the resol phenol resin (D) include Phenolite TD-447 (manufactured by DIC Corporation, cresol-type resin).

The total amount of the epoxy resin (C) and the resol phenol resin (D) is preferably 25 to 85 parts by mass, more preferably 30 to 80 parts by mass, and still more preferably 35 to 65 parts by mass, based on 100 parts by mass of the phenoxy resin (A). When the total amount is equal to or larger than a certain value, it is easier to further enhance the adhesive strength and the adhesion reliability of the cured product of the primer composition.

Further, the total amount of the epoxy resin (C) and the resol phenol resin (D) may be set according to the content of the melamine resin (B). For example, when the content of the melamine resin (B) is large, the total amount of the epoxy resin (C) and the resol phenol resin (D) may also be increased from the viewpoint of enhancing adhesiveness and adhesion reliability. That is, the content ratio of the total amount of the epoxy resin (C) and the resol phenol resin (D) to the melamine resin (B) is, for example, 50/50 to 60/40. When the content ratio of the melamine resin (B) is equal to or larger than a certain value, the coating film strength of the cured product of the primer composition is further easily increased, and when the content ratio is equal to or less than the certain value, the adhesive strength and the adhesion reliability of the cured product of the primer composition are further easily increased, and when the content ratio is equal to less than the certain value.

The content of the resol phenol resin (D) is preferably 40 to 60% by mass based on the total of the epoxy resin (C) and the resol phenol resin (D). When the content of the resol phenol resin (D) is within the above-described range, the curing reaction of the epoxy resin (C) and the reaction between the epoxy resin (C) and the phenoxy resin (A) are more likely to occur, and thus the adhesive strength and the adhesion reliability of the cured product are more likely to increase.

### 1-3-3. Palladium catalyst

The primer composition of the present invention may further contain a palladium catalyst. The palladium catalyst is preferably composed of palladium particles, and can function as a core agent for non-electrolytic plating. The palladium catalyst may be dispersed with a dispersant.

The average particle size of the palladium particles is not particularly limited, but may be, for example, 2 to 10 nm. The average particle size of palladium particles can be calculated by measuring the particle sizes of any 10 particles with a transmission electron microscope and taking the quantity average (as the quantity standard average size).

The content of the palladium catalyst is preferably, for example, 0.1 to 30% by mass with respect to the non-volatile component of the primer composition, more preferably 1 to 30% by mass, and still more preferably 1 to 5% by mass. When the content of the palladium catalyst is equal to or larger than a certain value, the adhesiveness to the non-electrolytic plating film of the obtained primer layer is easily increased to a sufficient extent, and when the content is equal to or less than the certain value, the coatability and the dispersion stability are less likely to be impaired.

### 1-3-4. Solvent

The primer composition of the present invention may further contain a solvent (dispersion medium) in which a palladium catalyst is dispersed. The solvent is preferably a solvent capable of dispersing a palladium catalyst or a dispersion thereof, and may be, for example, water or a non-protonic polar solvent.

Examples of the non-protonic polar solvent include N-methyl-2-pyrrolidone, dimethylformamide, dimethylacetamide, dimethyl sulfoxide, and γ-butyrolactone.

In addition, the primer composition may contain at least one of the following: alcohols such as methanol and ethanol; ketones such as acetone, methyl ethyl ketone, and cyclohexanone; glycol ethers such as ethylene glycol monomethyl ether and ethylene glycol monobutyl ether; aromatic carboxylic acid esters such as methyl benzoate, ethyl benzoate, and methyl salicylate; aromatic hydrocarbons such as toluene and xylene; glycol ether esters such as methyl cellosolve acetate, ethyl cellosolve acetate, butyl cellosolve acetate, methyl carbitol acetate, butyl carbitol acetate, and propylene glycol monomethyl ether acetate; and alkanol esters such as ethyl acetate and butyl acetate.

### 1-3-5. Silica particle

When the primer composition of the present invention includes a palladium catalyst, the primer composition preferably further includes silica particles. Silica particles may have a function mainly of enhancing the stability of a palladium catalyst.

As the silica particles, in addition to untreated silica particles, hydrophilic silica particles and hydrophobic silica particles can be used. The silica particles may have any shape, and may be, for example, spherical silica or crushed silica.

Among them, as the silica particles, hydrophobic silica particles are suitable from the viewpoint that aggregation between the silica particles is easily suppressed, and the stability in dispersion of the palladium catalyst is easily further enhanced. The hydrophobic silica particles are obtained by subjecting silica particles to surface treatment. As the surface treatment agent for the silica particles, for example, a silane coupling agent such as β-ethyltrimethoxysilane or γ-glycidoxypropyltrimethoxysilane, a treatment agent such as silicone oil, or the like can be used. Examples of the hydrophobic silica particles include organosilica sols such as Methanol Silica IPA-ST, NPC-ST-30, MEK-ST, PMA-ST, and MIBK-ST manufactured by Nissan Chemical Corporation.

The average particle size of the silica particles is preferably 10 to 100 nm, more preferably 10 to 50 nm. The average particle size can be measured by the cumulant method using a measurement instrument for dynamic light scattering. Further, in the same manner as described above, the measurement can be performed with a transmission electron microscope and calculated as the quantity standard average size.

The content of the silica particles is not particularly limited, but is, for example, 1 to 30% by mass with respect to the non-volatile component of the primer composition. Thus, the stability of the palladium catalyst can be further enhanced.

### 1-4. Manufacturing method

The primer composition of the present invention can be prepared by any method, and for example, can be obtained by mixing the above components.

The palladium catalyst may be added in a particulate state or may be added in a state in which the palladium catalyst is dispersed (as a dispersion) with a dispersant.

### 2. Laminate

The laminate of the present invention includes an insulation base material, a primer layer containing a cured product of a primer composition of the present invention, and a metal plating layer.

### (Insulation base material)

The insulation base material may be a resin base material or an inorganic base material such as ceramics or glass. Examples of the material constituting the resin base material include polyester, (meth)acrylic resin, polycarbonate, polystyrene, polyvinyl chloride, polyamide, polyimide (for example, MPI), BT resin (bismaleimide-triazine resin), polyetherimide, polyacetal, polyetheretherketone (PEEK), cyclic polyolefin (COC), polyolefin, polyphenylene sulfide (PPS), polysulfone, phenol resin, liquid crystal polymer (LCP), and fluororesin. Examples of ceramics constituting the inorganic base material include alumina.

Among them, when the laminate is a printed wiring board, particularly a printed wiring board used for a device compatible with a high frequency such as 5G, it is more preferable that the insulation base material is a insulation base material having a low dielectric constant (low-dielectric base material). Examples of the low-dielectric base material include resin having a low dielectric constant such as polyimide (MPI), BT resin (bismaleimide-triazine resin), polyetheretherketone (PEEK), cyclic polyolefin (COC), polyphenylene sulfide (PPS), liquid crystal polymer (LCP), and fluororesin, and glass, and may preferably be polyphenylene sulfide (PPS).

The thickness of the insulation base material is not particularly limited, but may be, for example, 12.5 to 50 µm.

### (Primer layer)

The primer layer contains the cured product of the primer composition of the present invention.

The primer layer may have any thickness as long as the thickness is enough to ensure the adhesive strength between the metal plating layer and the insulation base material. The thickness is particularly not limited, but is preferably smaller than the thickness of the metal plating layer. In particular, the cured product of the primer composition of the present invention exhibits satisfactory adhesive strength, and thus, it is possible to make the thickness of the primer layer sufficiently thin. Specifically, the thickness of the primer layer may be, for example, 0.05 to 0.5 µm.

### (Metal plating layer)

The metal plating layer is a layer obtained by bringing the surface of the primer layer into contact with a non-electrolytic plating solution, and includes metal such as copper, platinum, gold, silver, nickel, chromium, cobalt, tin, or the like. The metal plating layer preferably includes metal selected from the group consisting of copper, platinum, gold, silver, and nickel, and more preferably includes copper or an alloy thereof.

The thickness of the metal plating layer may be appropriately set according to the application, but may be, for example, 0.01 to 50 µm, preferably 0.1 to 10 µm, more preferably 0.1 to 2 µm when the metal plating layer is used for a printed wiring board.

The metal plating layer may be patterned into a predetermined shape. The metal plating layer formed in a pattern can function as, for example, a wiring pattern of a printed wiring board.

The laminate of the present invention can be used for a circuit formation substrate used for an electronic circuit, an integrated circuit, or the like, an organic EL element, an organic transistor, a flexible print board, an RFID, a transparent electrode used for a touch panel or the like, and an electromagnetic shield material. Among them, the laminate of the present invention can be suitably used for application in which durability at a high temperature is demanded. The laminate thus can be used for an application, which is generally referred to as a copper-clad laminate (CCL) for such as a flexible print circuit (FPC), a tape automated bonding (TAB), a chip on film (COF), or a printed wiring board (PWB).

### 3. Manufacturing method of laminate

The laminate of the present invention can be obtained by the following steps: 1) applying the primer composition of the present invention to the surface of an insulation base material, and then drying and curing the primer composition to form a primer layer, and 2) forming a metal plating layer on the primer layer by performing non-electrolytic plating.

### Regarding step of 1)

A primer composition of the present invention is applied to the surface of an insulation base material.

The method for applying the primer composition is not particularly limited, and may be, for example, a gravure printing method, a flexographic printing method, an inkjet method, a dipping method, a spray method, a spin coating method, a roll coating method, a reverse coating method, a screen printing method, or the like.

Subsequently, the applied primer composition is dried and cured to obtain a primer layer.

The drying and the curing can be performed by heating. The heating temperature may be such that the reaction between the phenoxy resin (A) and the melamine resin (B) in the primer composition sufficiently proceeds, and may be, for example, in a range of 60°C to 400°C, and may preferably be in a range of 80°C to 150°C. The heating time may be, for example, about 0.1 to 60 minutes, or preferably about 10 to 30 minutes, depending on the heating temperature.

### Regarding step of 2)

Subsequently, the surface of the primer layer on the insulation base material is brought into contact with a non-electrolytic plating solution to form a non-electrolytic plating film (metal plating layer).

From the viewpoint of efficiently performing the non-electrolytic plating, it is preferable that there is a palladium catalyst on the surface of the primer layer. As described above, the palladium catalyst may be included in the primer composition in advance, or may be further applied to the surface of the primer layer by, for example, bringing a solution containing a palladium catalyst into contact with the surface of the primer layer. From the viewpoint of effectively enhancing the reactivity with a non-electrolytic plating solution, a palladium catalyst is preferably included in the primer composition in advance.

The non-electrolytic plating solution may include the metal, a reducing agent, and water and/or a water-soluble organic solvent. The conditions for non-electrolytic plating may be set according to the composition of the non-electrolytic plating solution. For example, the temperature of the non-electrolytic copper plating bath may be, in general, about 25°C to 45°C. The processing time may vary depending on the application, and may be, for example, approximately 10 to 20 minutes in a case of forming a metal plating layer having a thickness of approximately 0.3 to 0.4 µm.

The metal plating layer may be formed in a pattern (full-additive method) or may be thinly formed on the entire surface of the primer layer (semi-additive method).

For example, for forming the metal plating layer in a pattern, the plating resist corresponding to a desired pattern is formed on the surface of the primer layer, the portion where the plating resist is not formed is subjected to non-electrolytic plating, and the metal plating layer is formed. Subsequently, the metal plating layer formed in a pattern (desired conductive pattern) can be obtained by dissolving and removing the plating resist with a chemical or the like (full additive method).

Alternatively, for thinly forming the metal plating layer on the entire surface of the primer layer, a second metal plating layer may be further formed on the metal plating layer in a pattern in the step of 3) to be described below (semi-additive method).

### Regarding step of 3)

As described above, the plating resist corresponding to a desired pattern may be formed on the surface of the metal plating layer (seed layer) thinly formed by non-electrolytic plating over the entire surface of the primer layer, and the second metal plating layer may be further formed by performing electrolytic plating on a portion where the plating resist is not formed. Subsequently, the plating resist is dissolved and removed with a chemical, and the unnecessary portion is further etched, and therefore the metal plating layer (desired conductive pattern) formed in a pattern can be obtained.

As described above, the print wiring board as a laminate can be manufactured by a semi-additive method or a full-additive method. Thus, it is possible to form a wiring pattern with a fine pitch.

These steps are usually performed in the roll-to-roll manner as described above. The primer composition of the present invention can be sufficiently cured in a relatively short time even in a production process using such a roll-to-roll method ((step 1) described above). Thus, it is possible to form a primer layer having a sufficient coating film strength, being less susceptible to damage due to friction with a roll or the like, and having excellent abrasion resistance. Further, since the primer layer has a suitable softness with not so high coating film strength, the primer layer is also excellent in reactivity when in contact with the non-electrolytic plating solution ((step 2) described above). Thus, it is possible to form the metal plating layer uniformly.

As described above, when the primer composition of the present invention is used, the insulation base material and the metal plating layer can be satisfactorily bonded to each other without etching the surface of the insulation base material, and therefore the skin effect is less likely to occur. Accordingly, the laminate of the present invention can be suitably used for a print wiring board (PWB) used for a device for a high frequency.

### Examples

Hereinafter, the present invention will be described in more detail with reference to Examples. However, the scope of the present invention is not limited thereto.

### 1. Material of primer composition

### <Material>

(1) Base resin
   - jER4250 (manufactured by Mitsubishi Chemical Corporation, a bisphenol A-type phenoxy resin/bisphenol F-type phenoxy resin mixed type, secondary hydroxyl equivalent: 270 g/eq, epoxy equivalent 7500 to 8900 g/eq, Mw: 60,000)
   - Teisa resin SG-80H (manufactured by NAGASE Chemtex Corporation, an acrylic acid ester-glycidyl methacrylate-acrylonitrile copolymer, epoxy equivalent 9100 g/eq, Mw: 350,000, Tg: 11°C)
   - Urethane-modified polyester copolymer (manufactured by TOYOBO CO., LTD., VYLON UR-3200)
(2) Melamine resin
   - U-VAN 703 (manufactured by Mitsui Chemicals, Inc., melamine resin)
(3) Epoxy resin
   - jER1031S (manufactured by Mitsubishi Chemical Corporation, tetraphenylethane epoxy resin, epoxy equivalent 200 g/eq, Mw: 800, solid)
(4) Resol phenol resin
   - Phenolite TD-447 (manufactured by DIC Corporation, resol-type phenol-based curing agent, cresol-modified type)
(5) Palladium catalyst
   - Pd nanopowder (manufactured by IOX Co., Ltd., ML-001N, average particle size: 5 nm)
(6) Silica particles (catalyst stabilizer)
   - PMA-ST (manufactured by Nissan Chemical Industries, Ltd., silica particle, average particle size 12 nm)

### 2. Production and evaluation of primer compositions

### [Examples 1 to 3 and Comparative Examples 1 to 7]

### (Preparation of primer composition)

A primer composition with a solid content concentration of 10% by mass was prepared by mixing the components described in Table 1 and a solvent (a solvent containing cyclohexanone, propylene glycol monomethyl ether acetate, methyl ethyl ketone, and N-methyl-2-pyrrolidone) such that the amounts of the components in resulting compositions are as described in Table 1.

### (Formation of primer layer)

A 50-µm-thick polyphenylene sulfide (PPS) film was prepared as an insulation base material. A primer composition in Table 1 was applied to one surface of the film with a bar coater, dried at 120°C for 5 minutes in a drying oven, further heated at 150°C for 30 minutes to be cured, and thus, a primer layer with a thickness of 0.5 µm was formed.

### (Non-electrolytic plating)

The film on which the primer layer was formed was immersed in a non-electrolytic plating bath, and non-electrolytic plating was performed. The non-electrolytic copper plating bath used was Sulcup PSY (Cu concentration 2 to 3 g/L) manufactured by Uemura Industrial Co., Ltd. Further, the non-electrolytic plating was performed at 35°C for 10 minutes such that the thickness of the plating layer became 0.2 µm.

### [Evaluation]

The abrasion resistance, the non-elctrolytic Cu plating reactivity, and the adhesiveness of the primer layer in a process of producing the laminate were evaluated by the following methods.

### (1) Abrasion resistance

A laminate of a PPS film and a primer layer was cut into a test piece having a size of 200 mm×30 mm. The surface hardness of the primer layer of this test piece was measured using a Rubbing Tester (Shinto Friction Tester) with Bencotto (a registered trademark of Asahi Kasei). The abrasion resistance was evaluated based on the following criteria.
∘: No scratch is formed
△: Three or fewer scratches are formed
×: More than three scratches are formed

The abrasion resistance was determined to be satisfactory when the abrasion resistance was △ or higher.

### (2) Non-electrolytic Cu plating reactivity

The sheet resistance of the plating layer surface obtained by non-electrolytic plating was measured with a surface resistance meter. Further, the non-electrolytic Cu plating reactivity was evaluated based on the following criteria.
∘: The seat resistance value is equal to or less than 0.25Ω/□
△: The sheet resistance is larger than 0.25Ω/□ and equal to or less than 0.9Ω/□
×: The seat resistance value is larger than 0.9Ω/□

It was determined that the plating layer was formed uniformly, and the non-electrolytic plating reactivity were satisfactory when the resistance was △ or higher.

### (3) Adhesiveness

### (Initial adhesiveness)

The adhesion of the plating layer of the obtained laminate was measured by a 90° peeling test. Specifically, the measurement was performed under the condition of a separation velocity of 25 mm/min at room temperature. Then, the adhesive strength was determined to be satisfactory when the adhesive strength was 5 N/cm or more.

### (Adhesion reliability)

The obtained laminate was stored in an air oven at 150°C for 168 hours. Subsequently, the adhesive strength of the plating layer was evaluated by the same method and criteria as described above.

The evaluation results of the primer compositions of Example 1 to 3 and Comparative Examples 1 to 7 are shown in Table 1.

**Table 11**

| | | | Unit | Example | | | Comparative example | | | | | | |
|---|---|---|---|---|---|---|---|---|---|---|---|---|---|
| | | | | 1 | 2 | 3 | 1 | 2 | 3 | 4 | 5 | 6 | 7 |
| Composition | Base resin | Phenoxy resin (A) | Parts by mass | 100 | 100 | 100 | 100 | 100 | 100 | - | - | - | - |
| | | Acrylic resin | | - | - | - | - | - | - | 100 | 100 | - | - |
| | | Polyester urethane resin | | - | - | - | - | - | - | - | - | 100 | 100 |
| | Thermosetting resin | Epoxy resin (C) | | 15 | 25 | 40 | 10 | 45 | 25 | 15 | 40 | 15 | 40 |
| | Curing agent | Resol phenol resin (D) | | 15 | 25 | 40 | 10 | 45 | 25 | 15 | 40 | 15 | 40 |
| | | Melamine resin (B) | | 30 | 50 | 60 | 20 | 70 | - | 30 | 60 | 30 | 60 |
| | Others | Pd catalyst | | 4 | 4 | 4 | 4 | 4 | 4 | 4 | 4 | 4 | 4 |
| | | Silica particle | | 10 | 10 | 10 | 10 | 10 | 10 | 10 | 10 | 10 | 10 |
| Evaluation | Abrasion resistance | | - | Δ | ○ | ○ | × | ⊚ | × | × | × | Δ | ○ |
| | Non-electrolytic Cu plating reactivity (10 min) | | - | ○ | ○ | Δ | × | × | × | × | × | ○ | Δ |
| | Sheet resistance | | Ω/□ | 0.1 | 0.1 | 0.3 | × | × | × | × | × | 0.2 | 0.3 |
| | Adhesiveness | Initial adhesiveness | N/cm | >5.0 | >10.0 | >5.0 | 2.0 | 1.0 | Unmeasurable | >5.0 | >5.0 | 1.0 | 1.0 |
| | | Adhesion reliability (150°C -168h) | N/cm | >5.0 | >10.0 | >5.0 | 2.0 | 1.0 | Unmeasurable | >5.0 | >5.0 | 1.0 | 1.0 |

As shown in Table 1, it has been found that the primer compositions of Examples 1 to 3 each containing at least a phenoxy resin (A) and a melamine resin (B) at a predetermined amount can form a primer layer with a high surface hardness and also have a satisfactory reactivity with a non-electrolytic plating solution. Further, it can be seen that the adhesiveness are also excellent.

In contrast, it has been found that the primer compositions of Comparative Examples 1 and 3 each containing a small or no amount of melamine resin (B) have a low coating film strength and a low abrasion resistance due to poor curing. Further, it can be found that the reactivity with the non-electrolytic plating solution is also low due to less exposure of the palladium catalyst. On the other hand, it has been found that the primer composition of Comparative Example 2 containing a large amount of melamine resin (B) has a high coating film strength, but has a low reactivity with the non-electrolytic plating solution because the coating film is too hard.

Further, it has been found that, as indicated in Table 1, the primer layers of Comparative Examples 4 and 5 whose primer compositions use an acrylic resin as the base resin have a low abrasion resistance and a low reactivity with the non-electrolytic plating solution; and the primer layers of Comparative Examples 6 and 7 whose primer compositions use a polyester urethane resin have a low adhesiveness.

This application claims priority based on Japanese Patent Application No. 2022-033771, filed on March 4, 2022, the disclosure of which including the specification and abstract is incorporated herein by reference in its entirety.

### Industrial Applicability

The present invention can provide a non-electrolytic plating primer composition capable of providing a primer layer having a sufficient coating film strength without decreasing reactivity with a non-electrolytic plating solution. For this reason, the non-electrolytic plating primer composition is suitably used for laminates obtaining a printed wiring board, in particular a printed wiring board used for a device compatible with a high frequency such as 5G.

## Claims

1. A non-electrolytic plating primer composition comprising:
a phenoxy resin (A); and
25 to 65 parts by mass of a melamine resin (B) based on 100 parts by mass of the phenoxy resin (A).

2. The non-electrolytic plating primer composition according to claim 1, further comprising:
an epoxy resin (C); and
a resol phenol resin (D).

3. The non-electrolytic plating primer composition according to claim 2, wherein
a total amount of the epoxy resin (C) and the resol phenol resin (D) is 30 to 80 parts by mass based on 100 parts by mass of the phenoxy resin (A).

4. The non-electrolytic plating primer composition according to claim 2, wherein
the epoxy resin (C) is a polyfunctional epoxy resin including three or more epoxy groups in a molecule thereof.

5. The non-electrolytic plating primer composition according to claim 2, wherein
the epoxy resin (C) is a solid epoxy resin.

6. The non-electrolytic plating primer composition according to claim 1, further comprising:
a palladium catalyst.

7. The non-electrolytic plating primer composition according to claim 6, wherein:
the palladium catalyst is a palladium particle; and
an average particle size of the palladium particle is 2 to 10 nm.

8. The non-electrolytic plating primer composition according to claim 6, wherein
a content of the palladium catalyst is 0.1% to 30% by mass with respect to a non-volatile component of the non-electrolytic plating primer composition.

9. The non-electrolytic plating primer composition according to claim 6, further comprising:
a silica particle.

10. A laminate comprising:
an insulation base material;
a primer layer disposed on the insulation base material and including a cured product of the non-electrolytic plating primer composition according to any one of claims 1 to 9; and
a metal plating layer disposed on the primer layer.

11. The laminate according to claim 10, wherein the insulation base material includes a resin selected from the group consisting of polyimide, BT resin, polyetheretherketone, cyclic polyolefin, polyphenylene sulfide, liquid crystal polymer, and fluororesin, the resin having a low dielectric constant.

12. A method for manufacturing a laminate, the method comprising:
forming a primer layer by applying the non-electrolytic plating primer composition according to any one of claims 1 to 9 to a surface of an insulation base material and by drying and curing the applied non-electrolytic plating primer composition; and
forming a metal plating layer on the primer layer by non-electrolytic plating.
